# EUROPEAN PATENT APPLICATION

(11) **EP 4 660 750 A1**
(43) Date of publication of application: **10.12.2025**
(21) Application number: 25180154.4
(22) Date of filing: 02.06.2025
(51) Int. Cl.: G06F 1/16, G06F 3/041, H04M 1/02

(54) **DISPLAY DEVICE**

(30) Priority: 03.06.2024 KR 20240072466
(71) Applicant: Samsung Display Co., Ltd., Yongin-si, Gyeonggi-do 17113 (KR)
(72) Inventor: KIM, Min Jee, Yongin-si, Gyeonggi-do (KR); JUNG, Sung Ki, Yongin-si, Gyeonggi-do (KR)
(74) Representative: Dr. Weitzel & Partner

(57) **Abstract**

A display device includes a display panel, a digitizer member disposed under the display panel, a shielding member disposed under the digitizer member, a first electromagnetic wave shielding layer disposed under the shielding member, a second electromagnetic wave shielding layer disposed under the shielding member and spaced apart from the first electromagnetic wave shielding layer, and a connection member disposed under the shielding member, disposed between the first electromagnetic wave shielding layer and the second electromagnetic wave shielding layer, and including an electromagnetic wave shielding sheet.

## Description

### BACKGROUND

### 1. Field

The invention relates to a display device. Specifically, the invention relates to a foldable display device.

### 2. Description of the Related Art

Recently, as interest in an information display is increased, research and development on a flexible display device including foldable, rollable, or the like is being continuously conducted.

### SUMMARY

The invention is defined by the independent claim. An aspect to be solved by the invention is to provide a display device having the same material and the same performance in a folding area and a non-folding area.

Aspects of the invention are not limited to the aspect described above, and other technical aspects which are not described will be clearly understood by those skilled in the art from the following description.

According to the invention, a display device includes a display panel, a digitizer member disposed under the display panel, a shielding member disposed under the digitizer member, a first electromagnetic wave shielding layer disposed under the shielding member, a second electromagnetic wave shielding layer disposed under the shielding member and spaced apart from the first electromagnetic wave shielding layer, and a connection member disposed under the shielding member, disposed between the first electromagnetic wave shielding layer and the second electromagnetic wave shielding layer, and including an electromagnetic wave shielding sheet.

In an embodiment, the shielding member may include a first shielding layer overlapping the first electromagnetic wave shielding layer in a plan view, and a second shielding layer overlapping the second electromagnetic wave shielding layer and spaced apart from the first shielding layer in the plan view.

In an embodiment, the connection member may connect the first shielding layer and the second shielding layer to each other.

In an embodiment, the connection member may be attached to each of the first shielding layer and the second shielding layer.

In an embodiment, an entirety of the first shielding layer and an entirety of the second shielding layer may each be integrally formed with the same material.

In an embodiment, the digitizer member may include a first digitizer overlapping the first shielding layer in the plan view, and a second digitizer overlapping the second shielding layer and spaced apart from the first digitizer in the plan view.

In an embodiment, the first shielding layer and the first digitizer may entirely overlap each other in the plan view, and the second shielding layer and the second digitizer may entirely overlap each other in the plan view.

In an embodiment, the electromagnetic wave shielding sheet may include at least one of copper, silver, or nickel.

In an embodiment, the electromagnetic wave shielding sheet may include the same material as the first electromagnetic wave shielding layer and the second electromagnetic wave shielding layer.

In an embodiment, the shielding member may include magnetic metal powder.

In an embodiment, the connection member may further include a support sheet disposed under the electromagnetic wave shielding sheet.

In an embodiment, the support sheet may include metal.

According to an embodiment of the invention, the display panel may include a first non-folding area, a second non-folding area, and a folding area between the first non-folding area and the second non-folding area, a first digitizer disposed under the display panel, a second digitizer may be disposed under the display panel and spaced apart from the first digitizer in a first direction, a first shielding layer may be disposed under the first digitizer, a second shielding layer may be disposed under the second digitizer and spaced apart from the first shielding layer in the first direction, a first electromagnetic wave shielding layer may be disposed under the first shielding layer, a second electromagnetic wave shielding layer may be disposed under the second shielding layer and spaced apart from the first electromagnetic wave shielding layer in the first direction, and a connection member may be disposed under the first shielding layer and the second shielding layer, may be disposed between the first electromagnetic wave shielding layer and the second electromagnetic wave shielding layer, may connect the first shielding layer and the second shielding layer to each other, and may overlap the folding area.

In an embodiment, the first digitizer may overlap the first non-folding area and at least a portion of the folding area, and the second digitizer may overlap the second non-folding area and at least a portion of the folding area.

In an embodiment, the first shielding layer may overlap the first non-folding area and at least a portion of the folding area, and the second shielding layer may overlap the second non-folding area and at least a portion of the folding area.

In an embodiment, the first electromagnetic wave shielding layer may overlap the first non-folding area, the second electromagnetic wave shielding layer may overlap the second non-folding area, and the first and second electromagnetic wave shielding layers may not overlap the folding area.

In an embodiment, a gap between the first shielding layer and the second shielding layer in the first direction may be defined in the folding area and may be less than a width of the folding area in the first direction.

In an embodiment, a gap between the first electromagnetic wave shielding layer and the second electromagnetic wave shielding layer in the first direction may be greater than a gap between the first shielding layer and the second shielding layer in the first direction.

In an embodiment, the electromagnetic wave shielding sheet may be disposed in the gap between the first electromagnetic wave shielding layer and the second electromagnetic wave shielding layer.

In an embodiment, the electromagnetic wave shielding sheet may overlap the first electromagnetic wave shielding layer and the second electromagnetic wave shielding layer in the first direction.

Specific details of other embodiments are included in the detailed description and drawings.

According to the embodiment described above, the shielding member may entirely overlap the folding area and the non-folding area, the shielding member may be entirely formed of the same material in the folding area and the non-folding area, and the display device may include the electromagnetic wave shielding member overlapping the non-folding area and the electromagnetic wave shielding sheet overlapping the folding area. Accordingly, an electromagnetic field signal may be shielded, electromagnetic interference may be shielded in the entire area of the display device, and different materials may not be used for each of the folding area and the non-folding areas in the shielding member. Accordingly, a structure of the display device may be simplified, a manufacturing cost may be reduced, and manufacturing efficiency may be improved.

An effect according to embodiments is not limited by the contents exemplified above, and more various effects are included in the present specification.

### BRIEF DESCRIPTION OF THE DRAWINGS

The above and other features of the invention will become more apparent by describing in further detail embodiments thereof with reference to the accompanying drawings, in which:
FIG. 1 is a block diagram illustrating a display device according to an embodiment of the invention;
FIG. 2 is a block diagram illustrating an embodiment of one of sub-pixels of FIG. 1;
FIG. 3 is a perspective view illustrating an embodiment of the display device of FIG. 1;
FIG. 4 is a diagram illustrating a folding state of the display device shown in FIG. 3;
FIG. 5 is a diagram schematically illustrating a folding state of the display device shown in FIG. 4 and a set member outside the display device;
FIG. 6 is a cross-sectional view taken along line I-I' of FIG. 3;
FIG. 7 is an enlarged cross-sectional view of a display panel of FIG. 6;
FIG. 8 is a cross-sectional view illustrating another embodiment of the display device of FIG. 6; and
FIGS. 9 to 13 are diagrams illustrating a method of manufacturing a display device according to an embodiment of the invention.

### DETAILED DESCRIPTION

The invention may be modified in various manners and have various forms. Therefore, specific embodiments will be illustrated in the drawings and will be described in detail in the specification. However, it should be understood that the invention is not intended to be limited to the disclosed specific forms, and the invention includes all modifications and substitutions within the technical scope of the invention.

Similar reference numerals are used for similar components in describing each drawing. In the accompanying drawings, the dimensions of the structures are shown enlarged from the actual dimensions for the sake of clarity of the invention. Terms of "first", "second", and the like may be used to describe various components, but the components should not be limited by the terms. The terms are used only for the purpose of distinguishing one component from another component. For example, without departing from the scope of the invention, a first component may be referred to as a second component, and similarly, a second component may also be referred to as a first component.

It should be understood that in the present application, a term of "include", "have", or the like is used to specify that there is a feature, a number, a step, an operation, a component, a part, or a combination thereof described in the specification, but does not exclude a possibility of the presence or addition of one or more other features, numbers, steps, operations, components, parts, or combinations thereof in advance. A case where a portion of a layer, a layer, an area, a plate, or the like is referred to as being "on" another portion, it includes not only a case where the portion is "directly on" another portion, but also a case where there is further another portion between the portion and another portion. In the present specification, when a portion of a layer, a layer, an area, a plate, or the like is formed on another portion, a forming direction is not limited to an upper direction but includes forming the portion on a side surface or in a lower direction. On the contrary, when a portion of a layer, a layer, an area, a plate, or the like is formed "under" another portion, this includes not only a case where the portion is "directly beneath" another portion but also a case where there is further another portion between the portion and another portion. Throughout the invention, the expression "at least one of a, b or c" indicates only a, only b, only c, both a and b, both a and c, both b and c, all of a, b, and c, or variations thereof.

Hereinafter, preferred embodiments of the invention and others necessary for those skilled in the art to understand the invention will be described in detail with reference to the accompanying drawings. In the following description, the singular expressions include plural expressions unless the context clearly dictates otherwise.

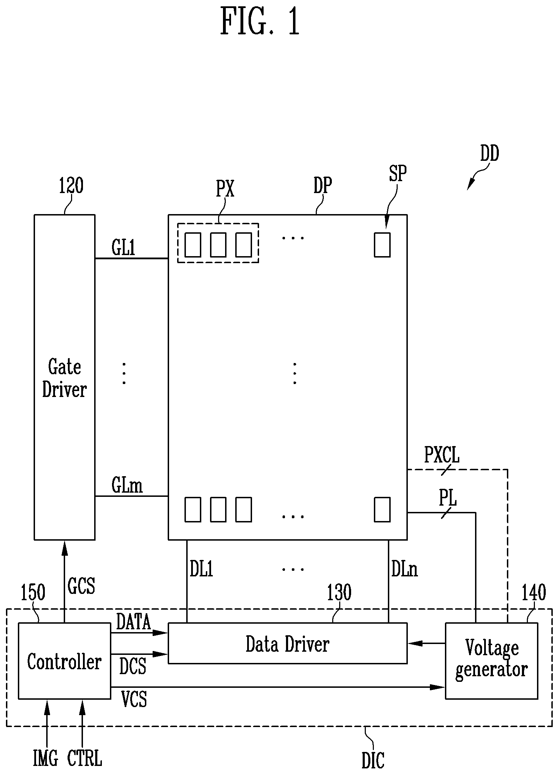

FIG. 1 is a block diagram illustrating a display device according to an embodiment of the invention.

Referring to FIG. 1, the display device DD may include a display panel DP, a gate driver 120, a data driver 130, a voltage generator 140, and a controller 150.

The display panel DP includes sub-pixels SP. The sub-pixels SP may be connected to the gate driver 120 through first to m-th gate lines GL1 to GLm. The sub-pixels SP may be connected to the data driver 130 through first to n-th data lines DL1 to DLn.

The sub-pixels SP may generate of light of two or more colors. For example, each of the sub-pixels SP may generate light such as red, green, blue, cyan, magenta, or yellow.

Two or more sub-pixels among the sub-pixels SP may configure one pixel PX. For example, the pixel PX may include three sub-pixels SP as shown in FIG. 1. As described above, the pixel PX may emit light of various colors and various luminances according to a combination of light emitted from the sub-pixels SP included in the pixel PX.

The gate driver 120 is connected to the sub-pixels SP arranged in a row direction through the first to m-th gate lines GL1 to GLm. The gate driver 120 may output gate signals to the first to m-th gate lines GL1 to GLm in response to a gate control signal GCS. In embodiments, the gate control signal GCS may include a start signal indicating a start of each frame, a horizontal synchronization signal, and the like.

The gate driver 120 may be disposed on one side of the display panel DP. However, embodiments are not limited thereto. For another example, the gate driver 120 may be divided into two or more physically and/or logically divided drivers, and the drivers may be disposed on one side of the display panel DP and another side of the display panel DP opposite the one side. As described above, the gate driver 120 may be disposed around the display panel DP in various shapes according to embodiments.

The data driver 130 is connected to the sub-pixels SP arranged in a column direction through the first to n-th data lines DL1 to DLn. The data driver 130 receives image data DATA and a data control signal DCS from the controller 150. The data driver 130 operates in response to the data control signal DCS. In embodiments, the data control signal DCS may include a source start signal, a source shift clock, a source output enable signal, and the like.

The data driver 130 may receive voltages from the voltage generator 140. The data driver 130 may apply data signals having grayscale voltages corresponding to the image data DATA to the first to n-th data lines DL1 to DLn using the received voltages. When the gate signal is applied to each of the first to m-th gate lines GL1 to GLm, the data signals corresponding to the image data DATA may be applied to the data lines DL1 to DLn. Accordingly, the sub-pixels SP may generate light corresponding to the data signals, and the display panel DP may display an image.

In embodiments, the gate driver 120 and the data driver 130 may include complementary metal-oxide semiconductor ("CMOS") circuit elements.

The voltage generator 140 may operate in response to a voltage control signal VCS from the controller 150. The voltage generator 140 is configured to generate a plurality of voltages and provide the generated voltages to components of the display device DD, such as the gate driver 120, the data driver 130, and the controller 150. The voltage generator 140 may generate the plurality of voltages by receiving an input voltage from an outside of the display device DD and regulating the received voltage.

The voltage generator 140 may generate a first power voltage and a second power voltage. The generated first and second power voltages may be provided to the sub-pixels SP through power lines PL. In another embodiment, at least one of the first and second power voltages may be provided from the outside of the display device DD.

In addition, the voltage generator 140 may provide various voltages and/or signals. For example, the voltage generator 140 may provide one or more initialization voltages applied to the sub-pixels SP. For example, during a sensing operation for sensing electrical characteristics of transistors and/or light emitting elements of the sub-pixels SP, a predetermined reference voltage may be applied to the first to n-th data lines DL1 to DLn, and the voltage generator 140 may generate the reference voltage and transmit the reference voltage to the data driver 130. For example, during a display operation for displaying an image on the display panel DP, common pixel control signals may be applied to the sub-pixels SP, and the voltage generator 140 may generate the pixel control signals. In embodiments, the voltage generator 140 may provide the pixel control signals to the sub-pixels SP through pixel control lines PXCL. In FIG. 1, the pixel control lines PXCL are connected between the voltage generator 140 and the display panel DP, but embodiments are not limited thereto. For another example, the pixel control lines PXCL may be connected between the gate driver 120 and the display panel DP. In this case, the pixel control signals may be transmitted from the voltage generator 140 to the pixel control lines PXCL through the gate driver 120.

The controller 150 controls overall operations of the display device DD. The controller 150 receives input image data IMG and a control signal CTRL corresponding thereto from the outside. The controller 150 may provide the gate control signal GCS, the data control signal DCS, and the voltage control signal VCS in response to the control signal CTRL.

The controller 150 may convert the input image data IMG so that the input image data IMG is suitable for the display device DD or the display panel DP and output the image data DATA. In embodiments, the controller 150 may output the image data DATA by aligning the input image data IMG so that the input image data IMG is suitable for the sub-pixels SP of a row unit.

Two or more components of the data driver 130, the voltage generator 140, and the controller 150 may be mounted on one integrated circuit. As shown in FIG. 1, the data driver 130, the voltage generator 140, and the controller 150 may be included in a driver integrated circuit DIC. In this case, the data driver 130, the voltage generator 140, and the controller 150 may be functionally divided components in one driver integrated circuit DIC. In other embodiments, at least one of the data driver 130, the voltage generator 140, or the controller 150 may be provided as a component distinguished from the driver integrated circuit DIC.

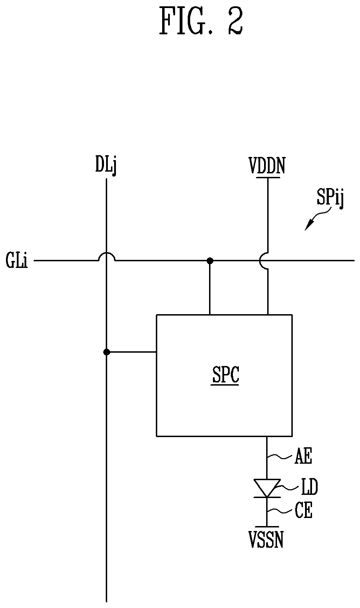

FIG. 2 is a block diagram illustrating an embodiment of one of the sub-pixels of FIG. 1.

In FIG. 2, among the sub-pixels SP of FIG. 1, a sub-pixel SPij arranged in an i-th row (i is an integer greater than or equal to 1 and less than or equal to m) and a j-th column (j is an integer greater than or equal to 1 and less than or equal to n) is shown as an example.

Referring to FIG. 2, the sub-pixel SPij may include a sub-pixel circuit SPC and a light emitting element LD.

The light emitting element LD is connected between a first power voltage node VDDN and a second power voltage node VSSN. The first power voltage node VDDN is connected to one of the power lines PL of FIG. 1 and receive the first power voltage. The second power voltage node VSSN may be connected to another one of the power lines PL of FIG. 1 and receives the second power voltage. The first power voltage may have a voltage level higher than a voltage level of the second power voltage.

The light emitting element LD is connected between an anode electrode AE and a cathode electrode CE. The anode electrode AE may be connected to the first power voltage node VDDN through the sub-pixel circuit SPC. For example, the anode electrode AE may be connected to the first power voltage node VDDN through one or more transistors included in the sub-pixel circuit SPC. The cathode electrode CE may be connected to the second power voltage node VSSN. The light emitting element LD is configured to emit light according to a current flowing from the anode electrode AE to the cathode electrode CE.

The sub-pixel circuit SPC may be connected to an i-th gate line GLi among the first to m-th gate lines GL1 to GLm of FIG. 1, and a j-th data line DLj among the first to n-th data lines DL1 to DLn of FIG. 1. In response to a gate signal received through the i-th gate line GLi, the sub-pixel circuit SPC may control the light emitting element LD to emit light according to a data signal received through the j-th data line DLj. In embodiments, the sub-pixel circuit SPC may be further connected to the pixel control lines PXCL of FIG. 1. In this case, the sub-pixel circuit SPC may control the light emitting element LD in further response to the pixel control signals received through the pixel control lines PXCL.

For such operations, the sub-pixel circuit SPC may include circuit elements, for example, transistors and one or more capacitors.

The transistors of the sub-pixel circuit SPC may include P-type transistors and/or N-type transistors. In embodiments, the transistors of the sub-pixel circuit SPC may include a metal oxide silicon field effect transistor ("MOSFET"). In embodiments, the transistors of the sub-pixel circuit SPC may include an amorphous silicon semiconductor, a monocrystalline silicon, a polycrystalline silicon semiconductor, an oxide semiconductor, and/or the like.

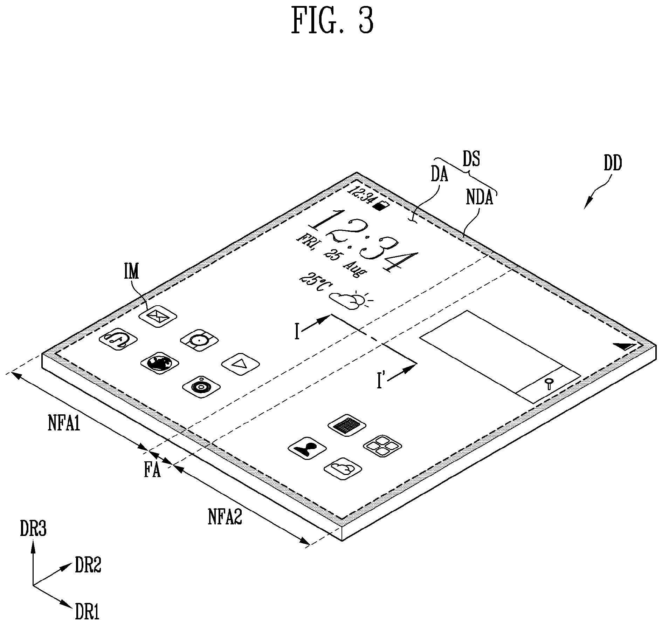

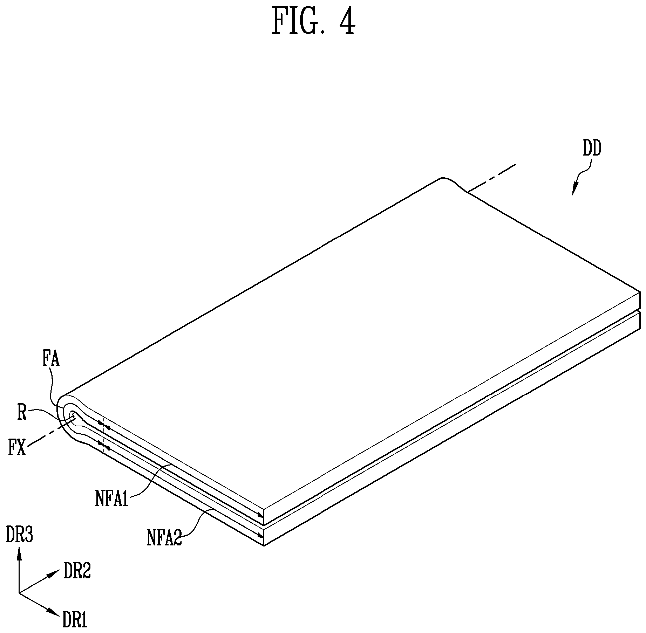

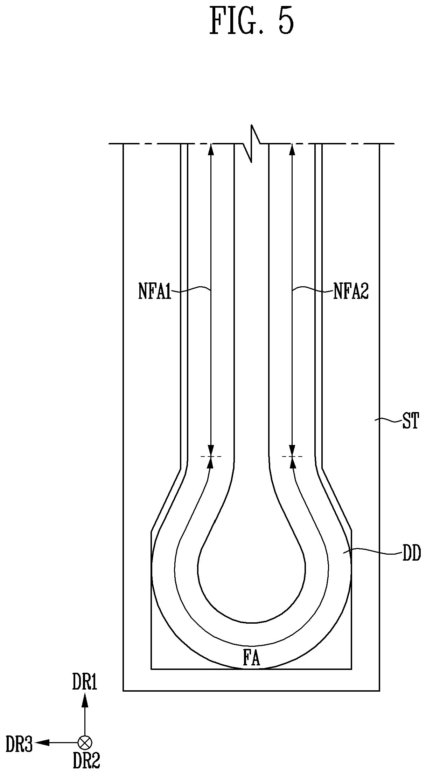

FIG. 3 is a perspective view illustrating an embodiment of the display device of FIG. 1. FIG. 4 is a diagram illustrating a folding state of the display device shown in FIG. 3. FIG. 5 is a diagram schematically illustrating a folding state of the display device shown in FIG. 4 and a set member outside the display device.

Referring to FIG. 3, the display device DD according to an embodiment of the invention may have a rectangular shape having short sides extending in a first direction DR1 and long sides extending in a second direction DR2 crossing the first direction DR1. However, a shape of the display device DD is not limited thereto, and a position of the short side and the long side of the display device DD may be interchanged, and the display device DD may have various shapes such as a circle and a polygon. The display device DD may be a flexible display device.

Hereinafter, a direction substantially perpendicularly crossing a plane defined by the first direction DR1 and the second direction DR2 is defined as a third direction DR3. The third direction DR3 may be defined as a thickness direction of the display device DD in an unfolded state. In addition, in this specification, "when viewed on a plane" (i.e., plan view) may be defined as a view in the third direction DR3 in the unfolded state.

The display device DD may include a folding area FA and a plurality of non-folding areas NFA1 and NFA2 adjacent to the folding area FA. The non-folding areas NFA1 and NFA2 may include a first non-folding area NFA1 and a second non-folding area NFA2. The second non-folding area NFA2 may be spaced apart from the first non-folding area NFA1 in the first direction DR1. The folding area FA may be disposed between the first non-folding area NFA1 and the second non-folding area NFA2. The first non-folding area NFA1, the folding area FA, and the second non-folding area NFA2 may be arranged in the first direction DR1.

As an example, one folding area FA and two non-folding areas NFA1 and NFA2 are shown, but the number of folding areas FA and non-folding areas NFA1 and NFA2 is not limited thereto. For another example, the display device DD may include more than two non-folding areas and a plurality of folding areas disposed between the non-folding areas.

An upper surface of the display device DD may be defined as a display surface DS, and the display surface DS may have the plane defined by the first direction DR1 and the second direction DR2. Images IM generated in the display device DD may be provided to a user through the display surface DS.

The display surface DS may include a display area DA and a non-display area NDA surrounding the display area DA. The display area DA may display an image, and the non-display area NDA may not display an image. The non-display area NDA may surround the display area DA and define a border of the display device DD that is printed in a predetermined color.

Although not shown, the display device DD may include at least one sensor and at least one camera. The sensor may be a near-illuminance sensor, but a type of the sensor is not limited thereto. The camera may capture an external image.

Referring to FIG. 4, the display device DD may be a foldable display device DD that is folded or unfolded. For example, the folding area FA may be bent about a folding axis FX parallel to the second direction DR2, and thus the display device DD may be folded. The folding axis FX may be defined as a long axis parallel to the long side of the display device DD. The folding area FA may be curved to have a radius of curvature R.

When the display device DD is folded, the first non-folding area NFA1 and the second non-folding area NFA2 may face each other, and the display device DD may be in-folded so that the display surface DS is not exposed to an outside. However, an embodiment of the invention is not limited thereto. For another example, the display device DD may be out-folded so that the display surface DS is exposed to the outside about the folding axis FX.

A distance between the first non-folding area NFA1 and the second non-folding area NFA2 may be less than twice the radius of curvature R. In this case, the folding area FA may be folded in a dumbbell shape.

Referring to FIG. 5, as the folding area FA is folded in the dumbbell shape, the first non-folding area NFA1 and the second non-folding area NFA2 may entirely contact each other, and a gap between the first non-folding area NFA1 and the second non-folding areas NFA2 may be entirely reduced. Through this, when the display device DD is folded, stability of a structure of the display device DD may be improved, and a thickness of the display device DD may be reduced.

A set member ST may be provided outside the display device DD. The set member ST may protect the display device DD and cover the display device DD from an outside of the display device DD in order to stabilize the structure of the display device DD when the display device DD is folded and unfolded.

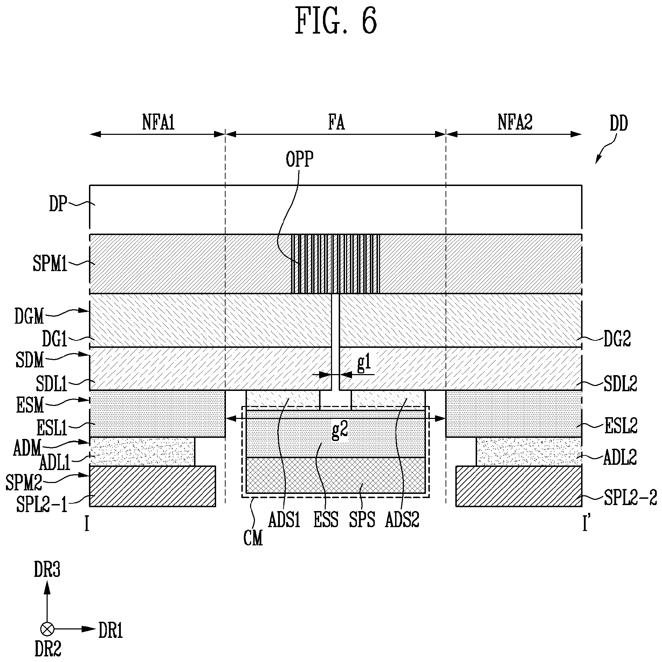

In this embodiment, when the display device DD is folded, due to the dumbbell shape of the folding area FA, interference between configurations (for example, a digitizer member DGM, a shielding member SDM, and the like of FIG. 6) of the display device DD extending from the non-folding areas NFA1 and NFA2 and having one end disposed in the folding area FA and the set member ST outside the display device DD may occur. To prevent this, in the folding area FA of the display device DD, a connection member (for example, a connection member CM of FIG. 6) that collects ends of configurations disposed in the non-folding areas NFA1 and NFA2 may be disposed. Due to the connection member, interference between internal configurations of the display device DD and the set member ST may be prevented, and the display device DD may be more stably folded and unfolded.

FIG. 6 is a cross-sectional view taken along line I-I' of FIG. 3.

Referring to FIG. 6, the display device DD may include a display panel DP, a first support member SPM1, the digitizer member DGM, the shielding member SDM, an electromagnetic wave shielding member ESM, an adhesive member ADM, a second support member SPM2, and the connection member CM. However, the invention is not limited thereto, and a glass layer, a protective layer, and/or the like may be further disposed on the display panel DP in another embodiment. In addition, although not shown, an adhesive layer may be further disposed between each of configurations.

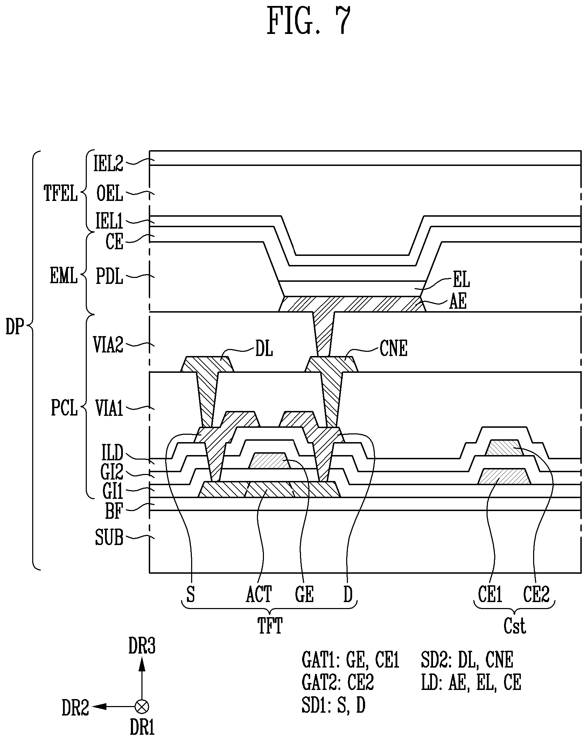

The display panel DP may have the folding area FA and the non-folding areas NFA1 and NFA2, as the display device DD has the folding area FA and the non-folding areas NFA1 and NFA2. The display panel DP is described in detail with reference to FIG. 7.

FIG. 7 is an enlarged cross-sectional view of the display panel of FIG. 6.

Referring to FIG. 7, the display panel DP may include a substrate SUB, a buffer layer BF, a circuit element layer PCL, a light emitting element layer EML, and a thin film encapsulation layer TFEL. The circuit element layer PCL may include thin film transistors TFT, a first gate insulating layer GI1, a first gate conductive layer GAT1, a second gate insulating layer GI2, a second gate conductive layer GAT2, an interlayer-insulating layer ILD, a first metal conductive layer SD1, a second metal conductive layer SD2, a first via-insulating layer VIA1, and a second via-insulating layer VIA2.

The substrate SUB may function to support various configurations disposed on the substrate SUB. The substrate SUB may be formed of an insulating material such as glass or resin.

In an embodiment, the substrate SUB may be formed of a flexible material that may be bendable or foldable, and may have a single layer structure or a multiple layer structure. The substrate SUB may include a polyimide substrate. However, the invention is not limited thereto, and for another example, the substrate SUB may include a glass substrate. As still another example, the substrate SUB may include a silicon wafer substrate formed using a semiconductor process.

The buffer layer BF may be disposed on the substrate SUB. The buffer layer BF may be disposed on an upper surface of the substrate SUB to protect the thin film transistors TFT and a light emitting layer EL of the light emitting element layer EML from moisture permeating through the substrate SUB, which is vulnerable to moisture permeation.

In an embodiment, the buffer layer BF may be an inorganic layer. The buffer layer BF may be configured of a plurality of inorganic layers alternately stacked. For example, the buffer layer BF may be formed of multiple layers in which one or more inorganic layers of a silicon nitride layer, a silicon oxy nitride layer, a silicon oxide layer, a titanium oxide layer, and an aluminum oxide layer are alternately stacked. In some embodiments, the buffer layer BF may be omitted.

The circuit element layer PCL including the thin film transistors TFT may be disposed on the buffer layer BF. The thin film transistor TFT may include an active layer ACT, a gate electrode GE, a source electrode S, and a drain electrode D. In FIG. 7, it is illustrated that the gate electrode GE of the thin film transistor TFT is disposed in a top gate manner in which the gate electrode GE is positioned on the active layer ACT, but the invention is not limited thereto. For another example, in some embodiments, the thin film transistors TFT may be disposed in a bottom gate manner in which the gate electrode GE is positioned under the active layer ACT or a double gate manner in which the gate electrode GE is positioned on and under the active layer ACT.

Specifically, the active layer ACT may be disposed on the buffer layer BF. The active layer ACT may include polycrystalline silicon, single crystalline silicon, low-temperature polycrystalline silicon, amorphous silicon, or an oxide semiconductor. For example, the oxide semiconductor may include a binary compound (ABx), a ternary compound (ABxCy), or a quaternary compound (ABxCyDz) including indium, zinc, gallium, tin, titanium, aluminum, hafnium (Hf), zirconium (Zr), magnesium (Mg), and/or the like. For example, the active layer ACT may include ITZO (oxide including indium, tin, and zinc) or IGZO (oxide including indium, gallium, and zinc).

The first gate insulating layer GI1 may be disposed on the active layer ACT. The first gate insulating layer GI1 may be disposed with substantially the same thickness along a profile of the active layer ACT. In an embodiment, the first gate insulating layer GI1 may be an inorganic layer. For example, the first gate insulating layer GI1 may be formed of a silicon nitride layer, a silicon oxy nitride layer, a silicon oxide layer, a titanium oxide layer, or an aluminum oxide layer. Although FIG. 5 illustrates that the first gate insulating layer GI1 is disposed in an area other than an area overlapping the gate electrode GE in a plan view, the invention is not limited thereto. For another example, in some embodiments, the first gate insulating layer GI1 may be disposed only in the area overlapping the gate electrode GE in a plan view.

The first gate conductive layer GAT1 may be disposed on the first gate insulating layer GI1. The first gate conductive layer GAT1 may include the gate electrode GE of the thin film transistor TFT, a first electrode CE1 of a storage capacitor Cst, and a scan line.

The first gate conductive layer GAT1 may be formed as a single layer or multiple layers formed of one of molybdenum (Mo), aluminum (Al), chromium (Cr), gold (Au), titanium (Ti), nickel (Ni), neodymium (Nd), and copper (Cu), or an alloy thereof.

The second gate insulating layer GI2 may be disposed on the first gate conductive layer GAT1. The second gate insulating layer GI2 may be disposed on the first gate insulating layer GI1 on which the first gate conductive layer GAT1 is disposed and may cover the first gate conductive layer GAT1. The second gate insulating layer GI2 may be disposed with substantially the same thickness along a profile of the first gate conductive layer GAT1. In an embodiment, the second gate insulating layer GI2 may be an inorganic layer. For example, the second gate insulating layer GI2 may include the same material as the first gate insulating layer GI1. However, the invention is not limited thereto.

The second gate conductive layer GAT2 may be disposed on the second gate insulating layer GI2. The second gate conductive layer GAT2 may include a second electrode CE2 of the storage capacitor Cst. For example, the second electrode CE2 may form the storage capacitor Cst with the first electrode CE1. The second electrode CE2 may overlap the first electrode CE1 in the third direction DR3.

The interlayer-insulating layer ILD may be disposed on the second gate insulating layer GI2 on which the second gate conductive layer GAT2 is disposed. In an embodiment, the interlayer-insulating layer ILD may be an inorganic layer. For example, the interlayer-insulating layer ILD may be formed of a silicon nitride layer, a silicon oxy nitride layer, a silicon oxide layer, a titanium oxide layer, or an aluminum oxide layer.

The first metal conductive layer SD1 may be disposed on the interlayer-insulating layer ILD. The first metal conductive layer SD1 may be formed as a single layer or multiple layers formed of one of molybdenum (Mo), aluminum (Al), chromium (Cr), gold (Au), titanium (Ti), nickel (Ni), neodymium (Nd), and copper (Cu), or an alloy thereof. For example, the first metal conductive layer SD1 may have a multiple layer structure. For example, the first metal conductive layer SD1 may have a two layer structure of Ti/Al or a three layer structure of Ti/Al/Ti.

The first metal conductive layer SD1 may include the source electrode S and the drain electrode D of the thin film transistor TFT. Each of the source electrode S and the drain electrode D may be connected to the active layer ACT through a contact hole passing through the first gate insulating layer GI1, the second gate insulating layer GI2, and the interlayer-insulating layer ILD.

The first via-insulating layer VIA1 may serve to partially insulate the first metal conductive layer SD1 and the second metal conductive layer SD2 to be described later and planarize a step generated by an element of the thin film transistor TFT. The first via-insulating layer VIA1 may be disposed on the interlayer-insulating layer ILD on which the first metal conductive layer SD1 is disposed. The first via-insulating layer VIA1 may be an organic layer. The first via-insulating layer VIA1 may be formed of an organic insulating material such as acryl-based resin, polyimide-based resin, or polyamide-based resin. For example, the first via insulation layer VIA1 may include at least one material among acryl resin, epoxy resin, phenolic resin, polyamide resin, and polyimide resin.

The second metal conductive layer SD2 may be disposed on the first via-insulating layer VIA1. The second metal conductive layer SD2 may include metal. The second metal conductive layer SD2 may include one or more metals selected from molybdenum (Mo), aluminum (Al), platinum (Pt), palladium (Pd), silver (Ag), magnesium (Mg), gold (Au), nickel (Ni), neodymium (Nd), iridium (Ir), chromium (Cr), calcium (Ca), titanium (Ti), tantalum (Ta), tungsten (W), and copper (Cu). For example, the second metal conductive layer SD2 may have a multiple layer structure. For example, the second metal conductive layer SD2 may have a two layer structure of Ti/Al or a three layer structure of Ti/Al/Ti.

The second metal conductive layer SD2 may include a connection electrode CNE, a data line DL, an initialization voltage line, and the like electrically connected to the source electrode S or the drain electrode D of the thin film transistor TFT. For example, the second metal conductive layer SD2 may include the connection electrode CNE electrically connected to the drain electrode D, as shown in FIG. 7. The connection electrode CNE may be electrically connected to the drain electrode D through a contact hole formed through the first via-insulating layer VIA1.

The second via-insulating layer VIA2 may be disposed on the first via-insulating layer VIA1 on which the second metal conductive layer SD2 is disposed. The second via-insulating layer VIA2 may be an organic layer. The second via-insulating layer VIA2 may include at least one material selected from acryl-based resin, polyimide-based resin, and polyamide-based resin.

The light emitting element layer EML is disposed on the circuit element layer PCL. The light emitting element layer EML includes light emitting elements LD and a pixel defining layer PDL.

Each of the light emitting elements LD may include an anode electrode AE, the light emitting layer EL, and a cathode electrode CE, and the light emitting elements LD and the pixel defining layer PDL may be disposed on the second via-insulating layer VIA2.

The anode electrode AE of the light emitting element LD may be electrically connected to the connection electrode CNE through a contact hole formed through the second via-insulating layer VIA2 and may be electrically connected to the drain electrode D of the thin film transistor TFT.

In a top emission structure, which emits light in a direction of the cathode electrode CE based on the light emitting layer EL, the anode electrode AE may be formed of a metal material having a high reflectance such as a stack structure of aluminum and titanium (Ti/Al/Ti), a stack structure of aluminum and ITO (ITO/Al/ITO), an APC alloy, and a stack structure of an APC alloy and ITO (ITO/APC/ITO). The APC alloy may be an alloy of silver (Ag), palladium (Pd), and copper (Cu). Alternatively, the anode electrode AE may be formed as a single layer of molybdenum (Mo), titanium (Ti), copper (Cu), of aluminum (Al).

In a bottom emission structure that emits light in a direction of the anode electrode AE based on the light emitting layer EL, the anode electrode AE may be formed of a transparent metal material (transparent conductive material ("TCO")) such as ITO or IZO that may transmit light, or may be formed of a semi-transmissive conductive material such as magnesium (Mg), silver (Ag), or an alloy of magnesium (Mg) and silver (Ag).

The pixel defining layer PDL may define an emission area of each of the sub-pixels SP. The pixel defining layer PDL may be disposed to partition the anode electrode AE on the second via-insulating layer VIA2. The pixel defining layer PDL may be disposed to cover an edge of the anode electrode AE. The pixel defining layer PDL may be an organic layer. For example, the pixel defining layer PDL may be formed of acryl resin, epoxy resin, phenolic resin, polyamide resin, polyimide resin, and/or the like.

The light emitting layer EL may be disposed on the anode electrode AE and the pixel defining layer PDL. In an embodiment, the light emitting layer EL may include an organic material and emit light of a predetermined color. For example, the light emitting layer EL may include a hole transporting layer, an organic material layer, and an electron transporting layer. In this case, the light emitting layer EL may emit light of one color among red, green, and blue.

The cathode electrode CE may be disposed on the light emitting layer EL. The cathode electrode CE may be disposed to cover the light emitting layer EL. The cathode electrode CE may be a common layer commonly disposed in pixels.

In the top emission structure, the cathode electrode CE may be formed of a transparent metal material (transparent conductive material (TCO)) such as ITO or IZO that may transmit light, or may be formed of a semi-transmissive conductive material such as magnesium (Mg), silver (Ag), or an alloy of magnesium (Mg) and silver (Ag).

In the bottom emission structure, the cathode electrode CE may be formed of a metal material having a high reflectance such as a stack structure of aluminum and titanium (Ti/Al/Ti), a stack structure of aluminum and ITO (ITO/Al/ITO), an APC alloy, and a stack structure of an APC alloy and ITO (ITO/APC/ITO). The APC alloy may be an alloy of silver (Ag), palladium (Pd), and copper (Cu). However, the invention is not limited thereto, and in another embodiment, the cathode electrode CE may be formed as a single layer of molybdenum (Mo), titanium (Ti), copper (Cu), aluminum (Al), or ITO.

The thin film encapsulation layer TFEL may be disposed on the light emitting element layer EML. Specifically, the thin film encapsulation layer TFEL may be disposed on the cathode electrode CE. The thin film encapsulation layer TFEL may include at least one inorganic layer to prevent oxygen or moisture from permeating into the light emitting layer EL and the cathode electrode CE. In addition, the thin film encapsulation layer TFEL may include at least one organic layer to protect the light emitting element layer EML from a foreign substance such as dust.

For example, the thin film encapsulation layer TFEL may include a first inorganic encapsulation layer IEL1 disposed on the cathode electrode CE, an organic encapsulation layer OEL disposed on the first inorganic encapsulation layer IEL1, and a second inorganic encapsulation layer IEL2 disposed on the organic encapsulation layer OEL. Each of the first inorganic encapsulation layer IEL1 and the second inorganic encapsulation layer IEL2 may be formed of a silicon nitride layer, a silicon oxy nitride layer, a silicon oxide layer, a titanium oxide layer, or an aluminum oxide layer, but is not limited thereto. The organic encapsulation layer OEL may be formed of acryl resin, epoxy resin, phenolic resin, polyamide resin, polyimide resin, or the like, but is not limited thereto.

Referring to FIG. 6 again, the first support member SPM1 may be disposed under the display panel DP. The first support member SPM1 may support the display panel DP.

A strength of the first support member SPM1 may be greater than a strength of the display panel DP. The first support member SPM1 may include a non-metal material. For example, the first support member SPM1 may include a reinforcing fiber composite. The reinforcing fiber composite may be carbon fiber reinforced plastic (CFRP) or glass fiber reinforced plastic (GFRP).

The first sup member SPM1 may overlap the non-folding areas NFA1 and NFA2 and the folding area FA of the display panel DP in a plan view. The first support member SPM1 may have opening patterns OPP that overlap the folding area FA in a plan view to reduce folding stress of the display device DD.

The digitizer member DGM may be disposed under the first support member SPM1. The digitizer member DGM may include electrode patterns for sensing approach or contact of an electronic pen such as a stylus pen that supports electromagnetic resonance (EMR). The digitizer member DGM may sense a magnetic field or electromagnetic signal emitted from the electronic pen based on the electrode patterns, and determine a point at which the sensed magnetic field or electromagnetic signal is largest as a touch coordinate.

The digitizer member DGM may include a first digitizer DG1 and a second digitizer DG2. The first digitizer DG1 may overlap the first non-folding area NFA1 and at least a portion of the folding area FA, and the second digitizer DG2 may overlap the second non-folding area NFA2 and at least a portion of the folding area FA. That is, the second digitizer DG2 may be spaced apart from the first digitizer DG1 in the first direction DR1.

The first digitizer DG1 and the second digitizer DG2 may be separated and spaced apart from each other in the folding area FA to reduce the folding stress of the display device DD. A gap between the first digitizer DG1 and the second digitizer DG2 may overlap the folding area FA and may be less than a width of the folding area FA.

The shielding member SDM may be disposed under the digitizer member DGM. The shielding member SDM may prevent the electromagnetic field signal from being emitted to a lower portion of the shielding member SDM. Specifically, the shielding member SDM may allow the electromagnetic field signal passing through the digitizer member DGM to flow to an inside of the shielding member SDM. Therefore, the shielding member SDM may reduce noise that may be generated by an electromagnetic field. The shielding member SDM may include magnetic metal powder.

The shielding member SDM may include a first shielding layer SDL1 and a second shielding layer SDL2. The first shielding layer SDL1 and the first digitizer DG1 may entirely overlap each other in a plan view, and the second shielding layer SDL2 and the second digitizer DG2 may entirely overlap each other in a plan view. That is, the first shielding layer SDL1 may overlap the first non-folding area NFA1 and at least a portion of the folding area FA, and the second shielding layer SDL2 may overlap the second non-folding area NFA2 and at least a portion of the folding area FA. The second shielding layer SDL2 may be spaced apart from the first shielding layer SDL1 in the first direction DR1.

The first shielding layer SDL1 and the second shielding layer SDL2 may be separated and spaced apart from each other in the folding area FA to reduce the folding stress of the display device DD. A gap g1 between the first shielding layer SDL1 and the second shielding layer SDL2 may overlap the folding area FA and may be less than the width of the folding area FA.

The entirety of the first shielding layer SDL1 may be integrally formed with the same material regardless of a location. Similarly, the entirety of the second shielding layer SDL2 may be integrally formed with the same material regardless of a location. That is, a portion of the first shielding layer SDL1 overlapping the first non-folding area NFA1 and a portion of the first shielding layer SDL1 overlapping the folding area FA may be integrally connected to each other and may include the same material. A portion of the second shielding layer SDL2 overlapping the second non-folding area NFA2 and a portion of the second shielding layer SDL2 overlapping the folding area FA may also be integrally connected to each other and may include the same material. Accordingly, when forming the shielding member SDM, since different materials are not required to be applied to a portion overlapping the non-folding areas NFA1 and NFA2 and a portion overlapping the folding area FA, a manufacturing cost of the display device DD may be reduced, and manufacturing efficiency may be improved.

The electromagnetic wave shielding member ESM may be disposed under the shielding member SDM. The electromagnetic wave shielding member ESM may shield electromagnetic interference (EMI) that reduces sensing sensitivity of the electronic pen of the digitizer member DGM or perform a heat dissipation function. The electromagnetic wave shielding member ESM may include a conductive material. For example, the electromagnetic wave shielding member ESM may include at least one of metals, such as copper (Cu), silver (Ag), and nickel (Ni).

The electromagnetic wave shielding member ESM may include a first electromagnetic wave shielding layer ESL1 and a second electromagnetic wave shielding layer ESL2. The first electromagnetic wave shielding layer ESL1 may overlap the first shielding layer SDL1 in the first non-folding area NFA1. However, the first electromagnetic wave shielding layer ESL1 may not overlap the first shielding layer SDL1 in the folding area FA. The second electromagnetic wave shielding layer ESL2 may overlap the second shielding layer SDL2 in the second non-folding area NFA2. However, the second electromagnetic wave shielding layer ESL2 may not overlap the second shielding layer SDL2 in the folding area FA. The second electromagnetic wave shielding layer ESL2 may be spaced apart from the first electromagnetic wave shielding layer ESL1 in the first direction DR1. The first electromagnetic wave shielding layer ESL1 may overlap the first non-folding area NFA1, the second electromagnetic wave shielding layer ESL2 may overlap the second non-folding area NFA2, and each of the first electromagnetic wave shielding layer ESL1 and the second electromagnetic wave shielding layer ESL2 may not overlap the folding area FA. However, the invention is not limited thereto.

The first electromagnetic wave shielding layer ESL1 and the second electromagnetic wave shielding layer ESL2 may be separated and spaced apart from each other with the folding area FA therebetween to reduce the folding stress of the display device DD. A gap g2 between the first electromagnetic wave shielding layer ESL1 and the second electromagnetic wave shielding layer ESL2 in the first direction DR1 may overlap the folding area FA and may be greater than or equal to the width of the folding area FA in the first direction DR1. In an embodiment, the gap g2 between the first electromagnetic wave shielding layer ESL1 and the second electromagnetic wave shielding layer ESL2 in the first direction DR1may be greater than the gap g1 between the first shielding layer SDL1 and the second shielding layer SDL2 in the first direction DR1.

The first digitizer DG1 may entirely overlap the first shielding layer SDL1 in a plan view, and the second digitizer DG2 may entirely overlap the second shielding layer SDL2 in a plan view, wherein the gap g1 may be formed between the first digitizer DG1 and the second digitizer DG2 and between the first shielding layer SDL1 and the second shielding layer SDL2.

The gap g1 between the first shielding layer SDL1 and the second shielding layer SDL2 may be smaller than the gap g2 between the first electromagnetic wave shielding layer ESL1 and the second electromagnetic wave shielding layer ESL2.

The connection member CM may be disposed under the shielding member SDM. The connection member CM may be attached to each of the first shielding layer SDL1 and the second shielding layer SDL2 through a first adhesive sheet ADS1 and the second adhesive sheet ADS2.

The connection member CM may be disposed between the first electromagnetic wave shielding layer ESL1 and the second electromagnetic wave shielding layer ESL2. That is, the connection member CM may overlap the folding area FA and may be disposed in the gap g2 between the first electromagnetic wave shielding layer ESL1 and the second electromagnetic wave shielding layer ESL2 in the first direction DR1. The connection member CM may have a smaller width than the gap g2.

The connection member CM may connect the first shielding layer SDL1 and the second shielding layer SDL2 to each other, and may perform a function of collecting ends of configurations under the display panel DP when the display device DD is folded. For example, the connection member CM may be attached to one end of the first shielding layer SDL1 and one end of the second shielding layer SDL2 to collect one end of the first shielding layer SDL1 and one end of the second shielding layer SDL2 so that one end of the first shielding layer SDL1 and one end of the second shielding layer SDL2 do not interfere with the set member ST of FIG. 5. The connection member CM may connect the first shielding layer SDL1 and the second shielding layer SDL2 to each other by the first adhesive sheet ADS1 and the second adhesive sheet ADS2. The first adhesive sheet ADS1 and the second adhesive sheet ADS2 may be spaced apart from each other. In particular, the first adhesive sheet ADS1 and the second adhesive sheet ADS2 may be not located in the gap g1.

The connection member CM may include an electromagnetic wave shielding sheet ESS and a support sheet SPS.

The electromagnetic wave shielding sheet ESS may be attached to the first shielding layer SDL1 through the first adhesive sheet ADS1 and may be attached to the second shielding layer SDL2 through the second adhesive sheet ADS2. The electromagnetic wave shielding sheet ESS may include the same material as the first electromagnetic wave shielding layer ESL1 and the second electromagnetic wave shielding layer ESL2. That is, the electromagnetic wave shielding sheet ESS may include a conductive material. For example, the electromagnetic wave shielding sheet ESS may include metal, for example, at least one of copper (Cu), silver (Ag), or nickel (Ni). However, the invention is not limited thereto.

The electromagnetic wave shielding sheet ESS may shield electromagnetic interference that reduces sensing sensitivity of the electronic pen of the digitizer member DGM or perform a heat dissipation function similarly to the first electromagnetic wave shielding layer ESL1 and the second electromagnetic wave shielding layer ESL2. Therefore, the first electromagnetic wave shielding layer ESL1 and the second electromagnetic wave shielding layer ESL2 may shield electromagnetic interference or perform a heat dissipation function in the first non-folding area NFA1 and the second non-folding area NFA2, respectively. The electromagnetic wave shielding sheet ESS may shield electromagnetic interference or perform a heat dissipation function in the folding area FA.

The electromagnetic wave shielding sheet ESS may be disposed in the gap g2 between the first electromagnetic wave shielding layer ESL1 and the second electromagnetic wave shielding layer ESL2, and may overlap the first electromagnetic wave shielding layer ESL1 and the second electromagnetic wave shielding layer ESL2 in the first direction DR1. However, the invention is not limited thereto, and in a case where the connection member CM further includes another member on the electromagnetic wave shielding sheet ESS, the electromagnetic wave shielding sheet ESS may not overlap the first electromagnetic wave shielding layer ESL1 and the second electromagnetic wave shielding layer ESL2 in the first direction DR1.

The support sheet SPS may be disposed under the electromagnetic wave shielding sheet ESS. The support sheet SPS may support and protect the electromagnetic wave shielding sheet ESS. The support sheet SPS may include metal. For example, the support sheet SPS may include stainless steel SUS, titanium, copper, and the like.

The connection member CM may further include an adhesive layer for coupling to the set member ST of FIG. 5 under the support sheet SPS. However, the invention is not limited thereto, and the adhesive layer may be omitted in another embodiment.

The second support member SPM2 may be attached to a lower portion of the electromagnetic wave shielding member ESM through the adhesive member ADM. That is, the adhesive member ADM may be disposed under the electromagnetic wave shielding member ESM, and the second support member SPM2 may be disposed under the adhesive member ADM through the adhesive member ADM. The second support member SPM2 may support components on the second support member SPM2.

The adhesive member ADM may include a first adhesive layer ADL1 and a second adhesive layer ADL2. The adhesive member ADM may include a transparent adhesive such as a pressure sensitive adhesive (PSA) or an optically clear adhesive (OCA). However, the invention is not limited thereto.

The second support member SPM2 may include a (2-1)-th support layer SPL2-1 and a (2-2)-th support layer SPL2-2. That is, the (2-1)-th support layer SPL2-1 may be attached to a lower portion of the first electromagnetic wave shielding layer ESL1 through the first adhesive layer ADL1, and the (2-2)-th support layer SPL2-2 may be attached to a lower portion of the second electromagnetic wave shielding layer ESL2 through the second adhesive layer ADL2.

The first adhesive layer ADL1 and the (2-1)-th support layer SPL2-1 may overlap the first electromagnetic wave shielding layer ESL1 in a plan view. The second adhesive layer ADL2 and the (2-2)-th support layer SPL2-2 may overlap the second electromagnetic wave shielding layer ESL2 in a plan view. The second adhesive layer ADL2 and the (2-2)-th support layer SPL2-2 may be spaced apart from the first adhesive layer ADL1 and the (2-1)-th support layer SPL2-1 in the first direction DR1, respectively. The first adhesive layer ADL1 and the (2-1)-th support layer SPL2-1 may overlap the first non-folding area NFA1, while the second adhesive layer ADL2 and the (2-2)-th support layer SPL2-2 may overlap the second non-folding area NFA2. Each of the adhesive member ADM and the second support member SPM2 may not overlap the folding area FA. However, the invention is not limited thereto.

The first adhesive layer ADL1 and the second adhesive layer ADL2 may be separated and spaced apart from each other with the folding area FA therebetween and the (2-1)-th support layer SPL2-1 and the (2-2)-th support layer SPL2-2 may be separated and spaced apart from each other with the folding area FA therebetween, to reduce the folding stress of the display device DD. A gap between the first adhesive layer ADL1 and the second adhesive layer ADL2 in the first direction DR1 and a gap between the (2-1)-th support layer SPL2-1 and the (2-2)-th support layer SPL2-2 in the first direction DR1 may be defined in the folding area FA and may each be greater than or equal to the width of the folding area FA in the first direction DR1. That is, the gap between the first adhesive layer ADL1 and the second adhesive layer ADL2 and the gap between the (2-1)-th support layer SPL2-1 and the (2-2)-th support layer SPL2-2 may each be greater or equal to the gap g2 between the first electromagnetic wave shielding layer ESL1 and the second electromagnetic wave shielding layer ESL2 in the first direction DR1. However, the invention is not limited thereto.

In an embodiment, each of the first shielding layer SDL1 and the second shielding layer SDL2 may be integrally formed in the folding area FA and the non-folding areas NFA1 and NFA2 with the same material, and the display device DD may include the electromagnetic wave shielding member ESM overlapping the non-folding areas NFA1 and NFA2 and the electromagnetic wave shielding sheet ESS overlapping the folding area FA. Therefore, an electromagnetic field signal may be shielded in the entire area of the display device DD, electromagnetic interference may be shielded, and different materials may not be used for each of the folding area FA and the non-folding areas NFA1 and NFA2 in the shielding member SDM. Accordingly, a structure of the display device DD may be simplified, a manufacturing cost may be reduced, and manufacturing efficiency may be effectively improved.

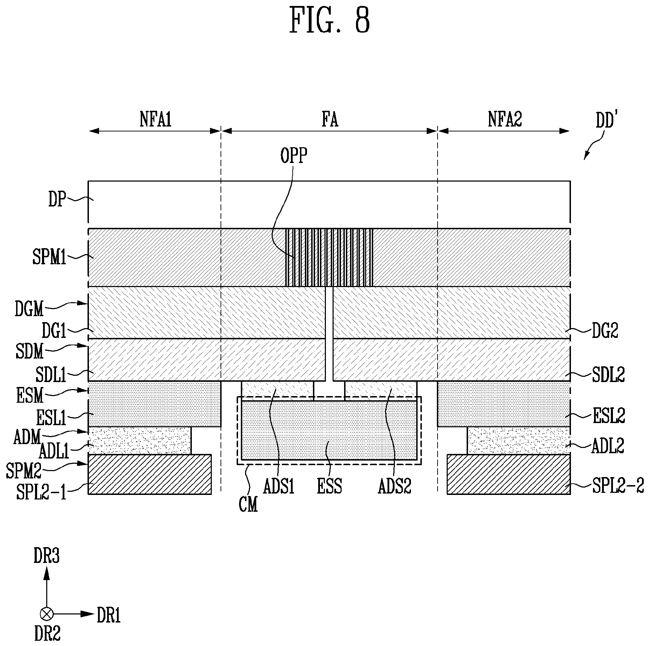

FIG. 8 is a cross-sectional view illustrating another embodiment of the display device of FIG. 6.

The display device DD' according to the present embodiment is different from the display device DD described above in an internal structure of the connection member CM. Therefore, a content that may overlap the content described above is briefly described or is not repeated.

Referring to FIG. 8, the connection member CM may include the electromagnetic wave shielding sheet ESS.

The electromagnetic wave shielding sheet ESS may be attached to the first shielding layer SDL1 through the first adhesive sheet ADS1 and may be attached to the second shielding layer SDL2 through the second adhesive sheet ADS2. The electromagnetic wave shielding sheet ESS may include the same material as the first electromagnetic wave shielding layer ESL1 and the second electromagnetic wave shielding layer ESL2. That is, the electromagnetic wave shielding sheet ESS may include a conductive material. For example, the electromagnetic wave shielding sheet ESS may include metal, for example, at least one of copper (Cu), silver (Ag), or nickel (Ni). However, the invention is not limited thereto.

In the connection member CM according to the present embodiment, differently from the connection member CM of FIG. 6, the support sheet SPS under the electromagnetic wave shielding sheet ESS may be omitted. Since the electromagnetic wave shielding sheet ESS may also be formed of metal similarly to the support sheet SPS, the electromagnetic wave shielding sheet ESS may also replace a function of the support sheet SPS. In another embodiment, the electromagnetic wave shielding sheet ESS and the support sheet SPS of FIG. 6 may include the same material. That is, the electromagnetic wave shielding sheet ESS and the support sheet SPS may be integrally formed, or the electromagnetic wave shielding sheet ESS and the support sheet SPS may be formed of one material. Therefore, the connection member CM may shield electromagnetic interference, and may support the connection member CM autonomously.

In an embodiment, since a separate material other than the electromagnetic wave shielding sheet ESS is not required when forming the connection member CM, a manufacturing cost of the connection member CM may be reduced, and a structure of the connection member CM may be simplified.

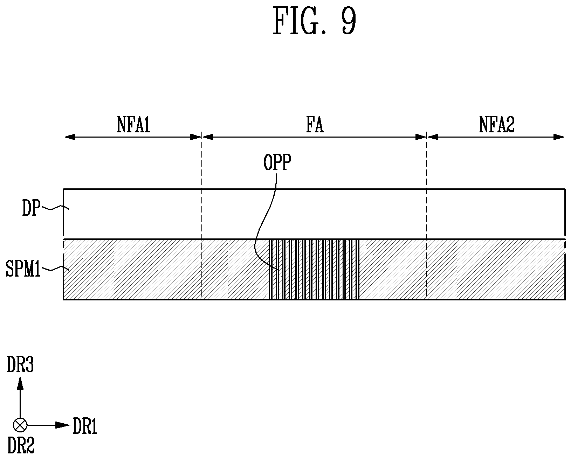

FIGS. 9 to 13 are diagrams illustrating a method of manufacturing a display device according to an embodiment of the invention.

FIGS. 9 to 13 illustrate a method of manufacturing the display device DD according to the embodiment described above with reference to FIGS. 1 to 7. A content that may overlap the content described above is briefly described or is not repeated.

Referring to FIG. 9, the first support member SPM1 may be formed under the display panel DP. A plurality of opening patterns OPP may be formed in a portion overlapping the folding area FA of the first support member SPM1.

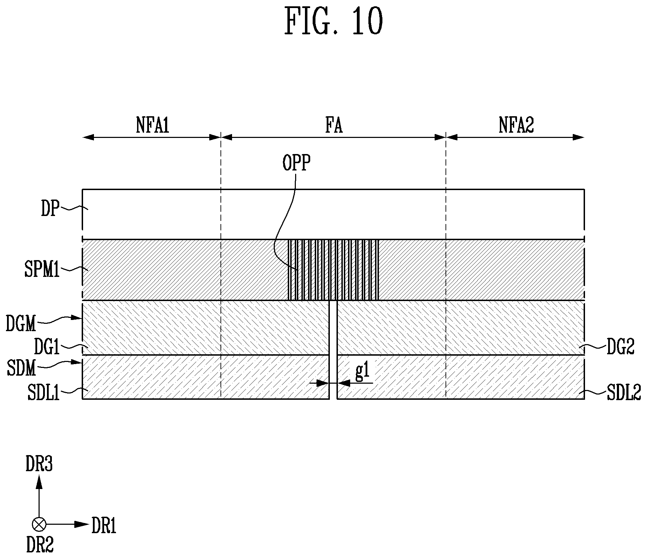

Referring to FIG. 10, the digitizer member DGM may be formed under the first support member SPM1. Specifically, the first digitizer DG1 may be formed under a portion overlapping the first non-folding area NFA1 and at least a portion of the folding area FA of the first support member SPM1. In addition, the second digitizer DG2 may be formed under a portion overlapping the second non-folding area NFA2 and at least a portion of the folding area FA of the first support member SPM1. The first digitizer DG1 and the second digitizer DG2 may be formed to be spaced apart from each other in the first direction DR1 to reduce folding stress.

The shielding member SDM may be formed under the digitizer member DGM. Specifically, the first shielding layer SDL1 may be formed under the first digitizer DG1. In addition, the second shielding layer SDL2 may be formed under the second digitizer DG2. The first shielding layer SDL1 and the second shielding layer SDL2 may be formed to entirely overlap the first digitizer DG1 and the second digitizer DG2, respectively. The first shielding layer SDL1 and the second shielding layer SDL2 may be formed to be spaced apart from each other by a predetermined gap g1 in the first direction DR1, and thus the folding stress of the display device DD may be effectively reduced.

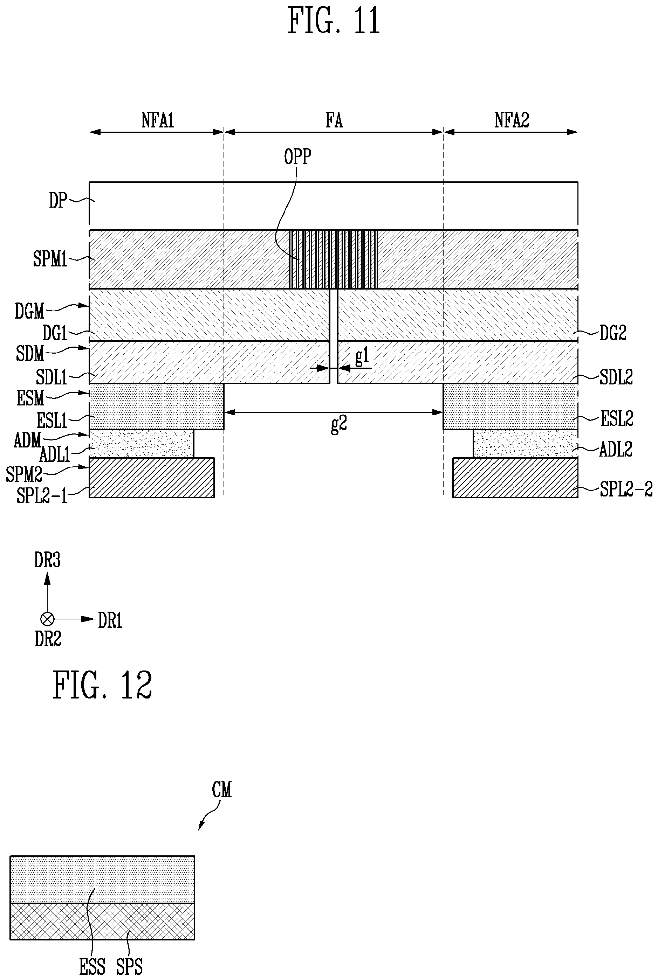

Referring to FIG. 11, the electromagnetic wave shielding member ESM may be formed under the shielding member SDM. Specifically, the first electromagnetic wave shielding layer ESL1 may be formed under a portion overlapping the first non-folding area NFA1 of the first shielding layer SDL1. In addition, the second electromagnetic wave shielding layer ESL2 may be formed under a portion overlapping the second non-folding area NFA2 of the second shielding layer SDL2. The first electromagnetic wave shielding layer ESL1 and the second electromagnetic wave shielding layer ESL2 may be formed to be spaced apart from each other by a predetermined gap g2 in the first direction DR1. In this embodiment, the gap g2 between the first electromagnetic wave shielding layer ESL1 and the second electromagnetic wave shielding layer ESL2 is greater than the gap g1 between the first shielding layer SDL1 and the second shielding layer SDL2 in the first direction DR1.

The second support member SPM2 may be formed under the electromagnetic wave shielding member ESM with the adhesive member ADM therebetween. Specifically, the first adhesive layer ADL1 and the (2-1)-th support layer SPL2-1 may be formed under the first electromagnetic wave shielding layer ESL1. In addition, the second adhesive layer ADL2 and the (2-2)-th support layer SPL2-2 may be formed under the second electromagnetic wave shielding layer ESL2. The first adhesive layer ADL1 and the second adhesive layer ADL2 may be formed to be spaced apart from each other in the first direction DR1, and the (2-1)-th support layer SPL2-1 and the (2-2)-th support layer SPL2-2 may be formed to be spaced apart from each other in the first direction DR1. In this embodiment, a gap between the first adhesive layer ADL1 and the second adhesive layer ADL2 in the first direction DR1 and a gap between the (2-1)-th support layer SPL2-1 and the (2-2)-th support layer SPL2-2 in the first direction DR1 may each be greater than or equal to the gap g2 between the first electromagnetic wave shielding layer ESL1 and the second electromagnetic wave shielding layer ESL2 in the first direction DR1.

Referring to FIG. 12, the connection member CM may be formed. Specifically, the electromagnetic wave shielding sheet ESS may be formed on the support sheet SPS.

The support sheet SPS may be formed of metal. For example, the support sheet SPS may be formed of stainless steel ("SUS"), titanium, copper, or the like.

In an embodiment, the electromagnetic wave shielding sheet ESS may be provided on the support sheet SPS. That is, the electromagnetic wave shielding sheet ESS may be stacked or attached on the support sheet SPS to be formed. The electromagnetic wave shielding sheet ESS may be formed of a conductive material. For example, the electromagnetic wave shielding sheet ESS may be formed of at least one of metals, for example, copper (Cu), silver (Ag), and nickel (Ni).

In another embodiment, an electromagnetic wave shielding paint may be plated or deposited on the support sheet SPS. That is, the electromagnetic wave shielding paint may be plated or deposited on the support sheet SPS to form the electromagnetic wave shielding sheet ESS. In this embodiment, the electromagnetic wave shielding paint may include at least one of metals, such as copper (Cu), silver (Ag), and nickel (Ni).

However, the invention is not limited thereto, and in another embodiment, the support sheet SPS and the electromagnetic wave shielding sheet ESS may be integrally formed (refer to FIG. 8), or the support sheet SPS and the electromagnetic wave shielding sheet ESS may be formed of the same material.

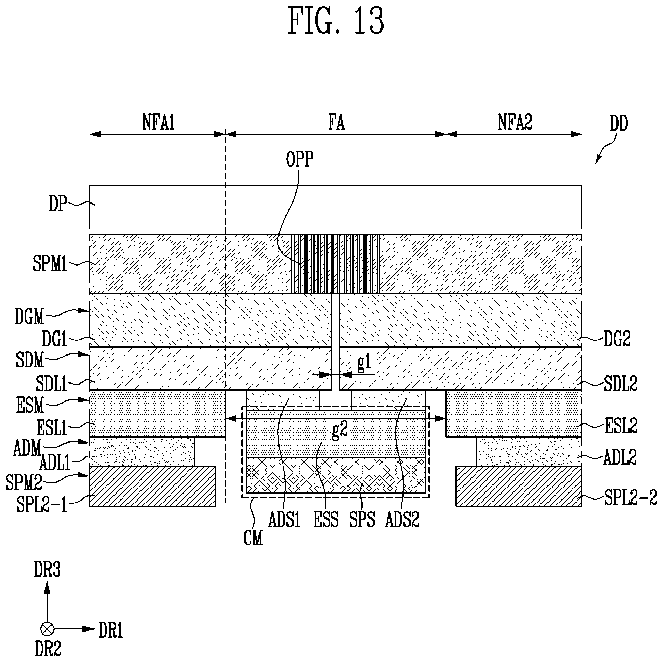

Referring to FIG. 13, the connection member CM may be provided in a gap defined in the electromagnetic wave shielding member ESM, the adhesive member ADM, and the second support member SPM2.

That is, the connection member CM may be provided in the gap g2 between the first electromagnetic wave shielding layer ESL1 and the second electromagnetic wave shielding layer ESL2, the gap between the first adhesive layer ADL1 and the second adhesive layer ADL2, and the gap between the (2-1)-th support layer SPL2-1 and the (2-2)-th support layer SPL2-2. The connection member CM may be attached to the first shielding layer SDL1 and the second shielding layer SDL2 through the first adhesive sheet ADS1 and the second adhesive sheet ADS2. As the connection member CM is provided in the folding area FA, interference between the internal configurations of the display device DD and the set member ST of FIG. 5 may be prevented when the display device DD is folded, and the display device DD may be more stably folded and unfolded.

Although the technical scope of the invention has been described in detail in accordance with the above-described embodiments, it should be noted that the above-described embodiments are for the purpose of description and not of limitation. Those skilled in the art can understand that various modifications are possible within the scope of the technical scope of the invention. The scope of the invention is not limited to the details described in the detailed description of the specification, but should be defined by the claims.

## Claims

1. A display device (DD) comprising:
a display panel (DP);
a digitizer member (DGM) disposed under the display panel (DP);
a shielding member (SDM) disposed under the digitizer member (DGM);
a first electromagnetic wave shielding layer (ESL1) disposed under the shielding member (SDM);
a second electromagnetic wave shielding layer (ESL2) disposed under the shielding member (SDM) and spaced apart from the first electromagnetic wave shielding layer (ESL1); and
a connection member (CM) disposed under the shielding member (SDM), disposed between the first electromagnetic wave shielding layer (ESL1) and the second electromagnetic wave shielding layer (ESL2), and including an electromagnetic wave shielding sheet (ESS).

2. The display device (DD) according to claim 1, wherein the shielding member (SDM) comprises:
a first shielding layer (SDL1) overlapping the first electromagnetic wave shielding layer (ESL1) in a plan view; and
a second shielding layer (SDL2) overlapping the second electromagnetic wave shielding layer (ESL2) and spaced apart from the first shielding layer (SDL1) in the plan view.

3. The display device (DD) according to claim 2, wherein the connection member (CM) connects the first shielding layer (SDL1) and the second shielding layer (SDL2) to each other.

4. The display device (DD) according to claim 2 or 3, wherein the connection member (CM) is attached to each of the first shielding layer (SDL1) and the second shielding layer (SDL2).

5. The display device (DD) according to at least one of claims 2 to 4, wherein an entirety of the first shielding layer (SDL1) and an entirety of the second shielding layer (SDL2) are each integrally formed with a same material.

6. The display device (DD) according to at least one of claims 2 to 5, wherein the digitizer member (DGM) comprises:
a first digitizer (DG1) overlapping the first shielding layer (SDL1) in a plan view; and
a second digitizer (DG2) overlapping the second shielding layer (SDL2) and spaced apart from the first digitizer (DG1) in the plan view.

7. The display device (DD) according to claim 6, wherein the first shielding layer (SDL1) and the first digitizer (DG1) entirely overlap each other in a plan view, and
the second shielding layer (SDL2) and the second digitizer (DG2) entirely overlap each other in the plan view.

8. The display device (DD) according to at least one of claims 1 to 7, wherein the electromagnetic wave shielding sheet (ESS) includes at least one of copper, silver, or nickel.

9. The display device (DD) according to at least one of claims 1 to 8, wherein the electromagnetic wave shielding sheet (ESS) includes a same material as the first electromagnetic wave shielding layer (ESL1) and the second electromagnetic wave shielding layer (ESL2).

10. The display device (DD) according to at least one of claims 1 to 9, wherein the shielding member (SDM) includes magnetic metal powder.

11. The display device (DD) according to at least one of claims 1 to 10, wherein the connection member (CM) further comprises a support sheet (SPS) disposed under the electromagnetic wave shielding sheet (ESS).

12. The display device (DD) according to claim 11, wherein the support sheet (SPS) includes metal.

13. The display device (DD) according to at least one of claims 1, 4, 5 or 8 to 12, wherein the display panel (DP) includes a first non-folding area (NFA1), a second non-folding area (NFA2), and a folding area (FA) between the first non-folding area (NFA1) and the second non-folding area (NFA2),
wherein the digitizer member (DGM) comprises a first digitizer (DG1) disposed under the display panel (DP), and a second digitizer (DG2) disposed under the display panel (DP) and spaced apart from the first digitizer (DG1) in a certain direction,
wherein the shielding member (SDM) comprises a first shielding layer (SDL1) disposed under the first digitizer (DG1), and a second shielding layer (SDL2) disposed under the second digitizer (DG2) and spaced apart from the first shielding layer (SDL1) in the direction,
wherein the first electromagnetic wave shielding layer (ESL1) is disposed under the first shielding layer (SDL1), and the second electromagnetic wave shielding layer (ESL2) is disposed under the second shielding layer (SDL2) and spaced apart from the first electromagnetic wave shielding layer (ESL1) in the direction, and
wherein the connection member (CM) is disposed under the first shielding layer (SDL1) and the second shielding layer (SDL2), connecting the first shielding layer (SDL1) and the second shielding layer (SDL2) to each other and overlapping the folding area (FA).

14. The display device (DD) according to claim 13, wherein the first digitizer (DG1) overlaps the first non-folding area (NFA1) and at least a portion of the folding area (FA), and
the second digitizer (DG2) overlaps the second non-folding area (NFA2) and at least a portion of the folding area (FA).

15. The display device (DD) according to claim 13 or 14, wherein the first shielding layer (SDL1) overlaps the first non-folding area (NFA1) and at least a portion of the folding area (FA), and
the second shielding layer (SDL2) overlaps the second non-folding area (NFA2) and at least a portion of the folding area (FA).

16. The display device (DD) according to at least one of claims 13 to 15, wherein the first electromagnetic wave shielding layer (ESL1) overlaps the first non-folding area (NFA1),
the second electromagnetic wave shielding layer (ESL2) overlaps the second non-folding area (NFA2), and
the first and second electromagnetic wave shielding layer (ESL2)s do not overlap the folding area (FA).

17. The display device (DD) according to at least one of claims 13 to 16, wherein a gap (g1) between the first shielding layer (SDL1) and the second shielding layer (SDL2) in the direction is defined in the folding area (FA) and is less than a width of the folding area (FA) in the direction.

18. The display device (DD) according to claim 17, wherein a gap (g2) between the first electromagnetic wave shielding layer (ESL1) and the second electromagnetic wave shielding layer (ESL2) in the direction is greater than the gap (g1) between the first shielding layer (SDL1) and the second shielding layer (SDL2) in the direction.

19. The display device (DD) according to claim 18, wherein the electromagnetic wave shielding sheet (ESS) is disposed in the gap (g2) between the first electromagnetic wave shielding layer (ESL1) and the second electromagnetic wave shielding layer (ESL2).

20. The display device (DD) according to at least one of claims 13 to 19, wherein the electromagnetic wave shielding sheet (ESS) overlaps the first electromagnetic wave shielding layer (ESL1) and the second electromagnetic wave shielding layer (ESL2) in the direction.
